# EUROPEAN PATENT APPLICATION

(11) **EP 4 496 438 A1**
(43) Date of publication of application: **22.01.2025**
(21) Application number: 24183474.6
(22) Date of filing: 20.06.2024
(51) Int. Cl.: H05K 1/11, H05K 3/42, H05K 1/02

(54) **PLATED VIA-IN-VIA VERTICAL CONNECTION**

(30) Priority: 19.07.2023 US 202318354907
(71) Applicant: Nokia Solutions and Networks Oy, 02610 Espoo (FI)
(72) Inventor: Brown, Paul, Wakefield, J0X 3G0 (CA); Chan, Alex, Ottawa, K2J5X9 (CA)
(74) Representative: Swindell & Pearson Limited

(57) **Abstract**

A method of manufacturing a via-in-via vertical interconnect in a printed circuit board (PCB), including: drilling a first hole through the PCB and through internal conductive layer 504; drilling a second hole into a top side of the PCB; plating the first hole and the second hole with a conductive material to form an outer layer 512; drilling a third hole through the PCB wherein a portion of the plating is removed between the first hole and the second hole; filling the first, second, and third holes with an outer filler 516; drilling a fourth hole through the outer filler; plating the fourth hole with a conductive material to form an inner layer 520; filling the fourth hole with an inner filler 522; forming a via-in-via pad 528 on top of the inner filler connected to the inner layer 520; and drilling a fifth hole 530 through the bottom of the PCB along the fourth hole to remove a portion of the inner filler and inner layer wherein the top of the fifth hole is below the internal layer 504.

## Description

### FIELD OF THE DISCLOSURE

This application relates to vertical interconnect structures with improved impedance control and signal isolation for the purpose of higher speed signal transmission in printed circuit boards (PCB).

### BACKGROUND

Current plated through hole vertical interconnect structures used for Printed Circuit Board signal transmission introduce excessive impedance variation and opportunity for cross-talk which limit their ability to support next generation high speed signal transmission. This application relates to vertical interconnect structures with improved impedance control and signal isolation to overcome these issues.

### SUMMARY

A summary of various exemplary embodiments is presented below.

Various embodiments relate to a method of manufacturing a via-in-via vertical interconnect in a printed circuit board (PCB), including: drilling a first hole through the PCB and through an internal conductive layer of the PCB; drilling a second hole into a top side of the PCB around the first hole, wherein a diameter of the second hole is greater than a diameter of the first hole and a bottom of the second hole is above the internal conductive layer; plating the first hole and the second hole with a conductive material to form an outer layer; drilling a third hole through the PCB along the second hole, wherein a diameter of the third hole is less than the diameter of the second hole and is greater than the diameter of the first hole, a bottom of the third hole is above the internal conductive layer, and a portion of the plating is removed between the first hole and the second hole; filling the first, second, and third holes with a first non-conductive filler material; drilling a fourth hole through the first non-conductive filler material; plating the fourth hole with a conductive material to form an inner layer; filling the fourth hole with a second non-conductive filler material; forming a via-in-via pad on top of the second non-conductive filler connected to the inner layer.

Various embodiments are described, wherein a fifth hole is drilled through the bottom of the PCB along the fourth hole to remove a portion of the second non-conductive filler and inner layer wherein the top of the fifth hole is below the internal conductive layer.

Various embodiments are described, wherein forming the via-in-via pad includes plating a conductive layer over the second non-conductive filler and etching the conductive layer over the second non-conductive filler to form top layer openings and the via-in-via pad.

Various embodiments are described, wherein the first hole is also drilled through a top conductive layer and a bottom conductive layer of the PCB.

Further various embodiments relate to a method of manufacturing a via-in-via vertical interconnect in a printed circuit board (PCB), including: drilling a first hole through the PCB and through a top layer and a bottom layer of the PCB; plating the first hole with a conductive material to form an outer layer; filling the first hole with an outer filler; drilling a second hole through the outer filler; plating the second hole with a conductive material to form an inner layer; filling the second hole with an inner filler; and forming a via-in-via pad on top of the inner filler connected to the inner layer.

Further various embodiments relate to a printed circuit board (PCB), including: an internal conductive layer; and a first via-in-via extending from a top surface of the PCB to the internal conductive layer, comprising: a first outer conductive layer; a first inner conductive layer inside the first outer conductive layer connected to the internal conductive layer; a first outer filler between the first outer conductive layer and the first inner conductive layer; a first inner filler inside the first inner conductive layer; and a first via-in-via pad over the first inner filler and connected to the first inner conductive layer.

Various embodiments are described, further including: a second via-in-via extending from a surface of the PCB to the internal conductive layer, including: a second outer conductive layer; a second inner conductive layer inside the second outer conductive layer connected to the internal conductive layer; a second outer filler between the second outer conductive layer and the second inner conductive layer; a second inner filler inside the second inner conductive layer; and a second via-in-via pad over the second inner filler and connected to the second inner conductive layer, wherein the second via-in-via pad is electrically connected to the first via-in-via pad.

Various embodiments are described, wherein the second via-in-via extends from the top surface of the PCB.

Various embodiments are described, wherein the second via-in-via extends from a bottom surface of the PCB.

The foregoing has outlined rather broadly the features and technical advantages of examples according to the disclosure in order that the detailed description that follows may be better understood. Additional features and advantages will be described hereinafter. The conception and specific examples disclosed may be readily utilized as a basis for modifying or designing other structures for carrying out the same purposes of the present disclosure. Such equivalent constructions do not depart from the scope of the appended claims. Characteristics of the concepts disclosed herein, both their organization and method of operation, together with associated advantages will be better understood from the following description when considered in connection with the accompanying figures. Each of the figures is provided for the purposes of illustration and description, and not as a definition of the limits of the claims.

### BRIEF DESCRIPTION OF DRAWINGS

So that the above-recited features of the present disclosure can be understood in detail, a more particular description, briefly summarized above, may be had by reference to aspects, some of which are illustrated in the appended drawings. It is to be noted, however, that the appended drawings illustrate only certain typical aspects of this disclosure and are therefore not to be considered limiting of its scope, for the description may admit to other equally effective aspects. The same reference numbers in different drawings may identify the same or similar elements.
FIG. 1 illustrates an embodiment of a via-in-via vertical interconnect.
FIG. 2 illustrates a coaxial cable connected to the PCB.
FIG. 3 illustrates how a signal from the top of the PCB may be connected to an internal layer of the PCB using a via-in-via vertical connection.
FIG. 4 illustrates the use of two via-in-via vertical interconnects to provide a connection between two locations on the upper surface of the PCB.
FIGs. 5A-5K illustrate the various steps carried out to manufacture a via-in-via vertical interconnect

### DETAILED DESCRIPTION

Various aspects of the disclosure are described more fully hereinafter with reference to the accompanying drawings. This disclosure may, however, be embodied in many different forms and should not be construed as limited to any specific structure or function presented throughout this disclosure. Rather, these aspects are provided so that this disclosure will be thorough and complete and will fully convey the scope of the disclosure to those skilled in the art. Based on the teachings herein one skilled in the art should appreciate that the scope of the disclosure is intended to cover any aspect of the disclosure disclosed herein, whether implemented independently of or combined with any other aspect of the disclosure. For example, an apparatus may be implemented or a method may be practiced using any number of the aspects set forth herein. In addition, the scope of the disclosure is intended to cover such an apparatus or method which is practiced using other structure, functionality, or structure and functionality in addition to or other than the various aspects of the disclosure set forth herein. It should be understood that any aspect of the disclosure disclosed herein may be embodied by one or more elements of a claim.

Several aspects of via in via connections will now be presented with reference to various apparatuses and techniques. These apparatuses and techniques will be described in the following detailed description and illustrated in the accompanying drawings by various blocks, modules, components, circuits, steps, processes, algorithms, and/or the like (collectively referred to as "elements").

Printed circuit board (PCB) technology has evolved considerably over the years to keep pace with ever increasing signal speeds. Controlled impedance, new ultra-low loss dielectrics, smoother copper foils, backdrilling of plated through holes are a few key examples of changes that have allowed boards to function properly at these higher speeds. However at its core, the PCB remains an imperfect vehicle for the transmission of high speed signals because of the way that it is made. Lamination of multiple conductive layers allows for effective isolation of signal and adequate reference to ground in the vertical axis, but in the horizontal axis, these signals must navigate around multiple structures (e.g., other signals, other vertical interconnects, and reference plane openings) each one leading to a discontinuity in the impedance of the vertical connection. At lower speeds these discontinuities were manageable, however at 112 Gbps speeds these discontinuities can be crippling, and the ability to tune the designs by adjusting for the effect of each discontinuity is becoming impossible given the density of signals and the fact that each signal must follow its own unique path. To some extent these shortcomings have been anticipated with the expectation that fiber optics would provide a path forward, however due to technical challenges, it is clear that an effective replacement to electrical signal routing at the device and PCB level is still a way off.

Despite having evolved considerably since their introduction, the basic structure and usage of PCBs has remained fundamentally the same; photo lithography defined circuit conductors on sheets of copper foil, for the in-plane transmission of signals, with these layers being laminated together separated by dielectric separators and subsequently drilled and plated for the vertical transmission of signals. This still largely represents the state of the art. As with most electronics, miniaturization of features and tighter tolerance processes have allowed successive improvement in density and impedance control. These fundamental aspects of PCB construction limit the extent to which discontinuities in the signal's impedance may be eliminated. Some conceptual designs do anticipate routing high speed signals from chip to chip or from chip to connector without needing to go through the printed wiring board, by virtue of fiber optic links or coaxial connections at the chip substrate level, however many technical challenges remain to be resolved before this becomes a viable solution.

Designs operating at the current maximum signal speed of 112 Gbps are showing that conventional PCB technology is truly approaching its limit. Embodiments of a via-in-via vertical interconnect are disclosed that would enable transmission of signals at 112 Gbps and even 224 Gbps without these limitations.

To resolve the problem of numerous and excessive discontinuities encountered by high speed signals as they pass through the printed wiring board, it is necessary to extend the ground shielding to the vertical interconnect so that the signal has a stable and near continuous reference as it passes through the board. Additionally, it is important that this be accomplished using traditional multilayer printed wiring board processes so that the remainder of the printed wiring board can continue to support all of its other functions (low speed routing, power distribution, mechanical support, and the like). The via-in-via vertical interconnect provides continuous ground shielding around the signal via as it passes through the board. This via-in-via vertical interconnect may be produced using conventional fabrication processes and a process flow that still allows the printed wiring board to fulfill its other functions.

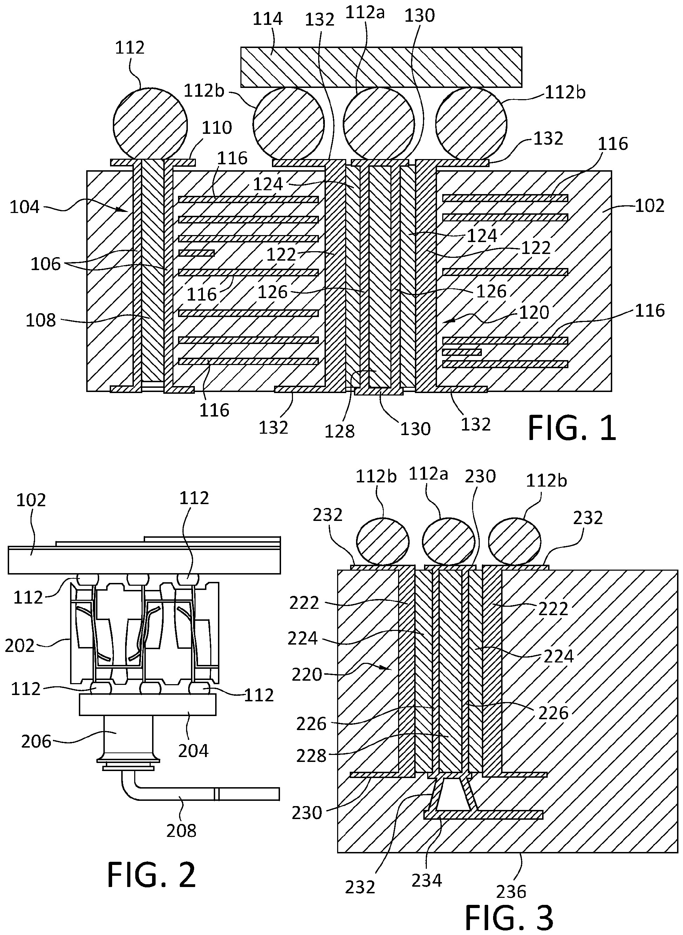

FIG. 1 illustrates an embodiment of a via-in-via vertical interconnect. A conventional via vertical interconnect 104 is also illustrated for comparison.

The conventional via vertical interconnect 104 is formed by drilling a hole through a PCB 102. Next a copper layer is plated in the hole to form a conductive vertical cylinder (or via) 106 and a via pad 110. Then the plated hole may be filled with via filling polymer 108. Then a solder ball 112 may be soldered to the via pad 110 to facilitate a connection to another device. These conventional via vertical interconnects 104 pass through internal layers connecting only to those required to complete the circuit.

As shown in FIG. 1, the PCB 102 include a variety of ground layers 116. Some of these ground layers 116 are near the via 106 and these ground layers 116 cause variations in the impedance of the conventional via vertical interconnect 104 as the signal travels through said via. As described above, as the speed of the signals increase to 112 Gbps or even 224 Gbps, these variations in the impedance of the conventional via vertical interconnect 104 start to cause problems with the integrity of the high speed signals.

A via-in-via vertical interconnect 120 is also illustrated in FIG. 1. The via-in-via vertical interconnect 120 includes an inner plated cylinder inside an outer plated ground cylinder. The outer ground cylinder shields the inner cylinder from the effects of the ground layers 116 while also providing a consistent reference surface. Broadly, the via-in-via vertical interconnect 120 is formed by first drilling a hole in the PCB 102. Then the hole is plated with a copper to form an outer conductive cylinder 122 and a via-in-via ground pad 132. Next, the plated hole is filled with polymer filler 124. It is noted that the filler material may be any non-conductive filler material. Next a second hole is drilled through the polymer filler 124. Typically this second hole will generally be along and generally centered in the first hole. The second hole is plated with a copper to form an inner conductive cylinder. Then the plated second hole is filled with polymer filler 128. Then an additional copper layer may be plated at the ends of the via-in-via vertical interconnect 120 to form the via-in-via pad 130 that is connected to the inner layer 126.

An integrated circuit (IC) 114 may be attached to the via-in-via vertical interconnect 120 using solder balls 112. One solder ball 112a may be connected to the via-in-via pad 130 and two solder balls 112b are connected to the via-in-via ground pad 132. This means that the IC 114 will see a constant impedance along the inner connection of the via-in-via vertical interconnect 120 formed by the inner cylinder 126 because the inner cylinder 126 is shielded by the outer ground cylinder 122.

FIG. 2 illustrates a coaxial cable 208 connected to the PCB 102. High speed signals may be connected to the PCB 102 by a coaxial cable 208 via a coaxial connector 206. The coaxial connector 206 may be connected to a connector board 204. A PCB connector 202 may then connect the connector board 204 to the PCB 102 using solder balls 112. The high speed signals from the coaxial cable 208 may then pass through the PCB 102 using the via-in-via vertical interconnect 120 (not shown in FIG. 2).

FIG. 1 illustrates the use of the via-in-via vertical interconnect 120 to pass a signal from one side of the PCB 102 to the other. FIG. 3 illustrates how a signal from the top of the PCB 102 may be connected to an internal layer of the PCB 102 using a via-in-via vertical connection. In this example, the via-in-via vertical interconnect 220 includes an outer cylinder 222, outer filler 224, inner cylinder 226, inner filler 228, and via-in-via pad 230 like the via-in-via vertical interconnect 120. Here the lower via-in-via pad 230 ends at a via-in-via pad 230 internal to the PCB 102 at a first layer. This via-in-via pad 230 may then be connected to a second layer 234 using a microvia 232. The signal on the second layer 234 may then be transmitted to some other part of the PCB 102. In other embodiments, the via-in-via vertical interconnect 220 may just be connected to the first layer.

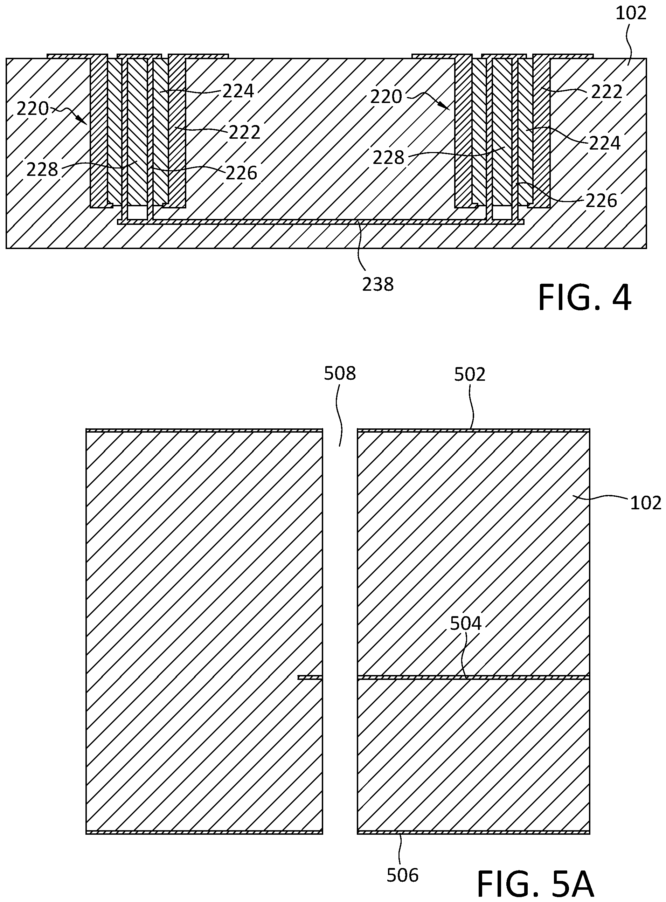

FIG. 4 illustrates the use of two via-in-via vertical interconnects 220 to provide a connection between two locations on the upper surface of the PCB 102. Each of the via-in-via vertical interconnects 220 are connected to an internal layer 238 so that a high speed signal may pass from one via-in-via vertical interconnect 220 to the other. The via-in-via vertical interconnects 220 may be connected directly to the internal layer 238 or may be connected using a microvia as illustrated in FIG. 3.

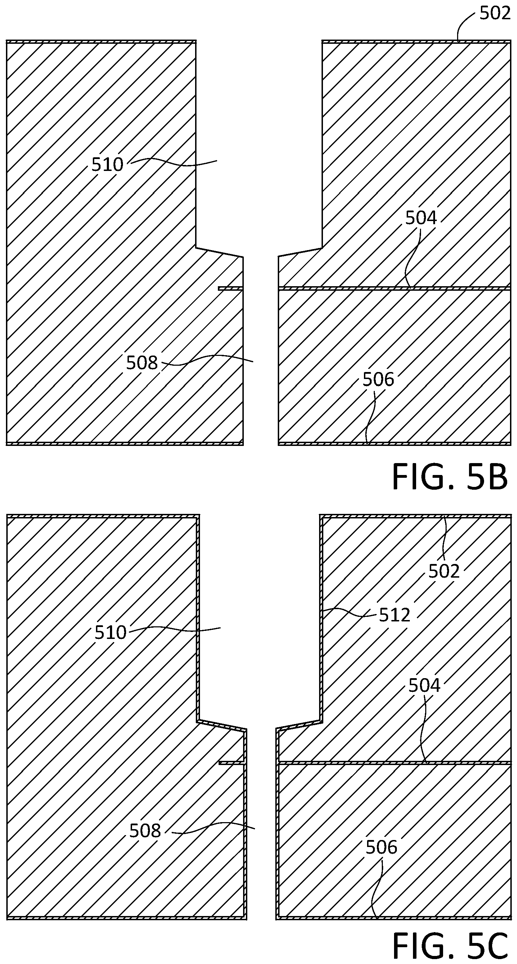

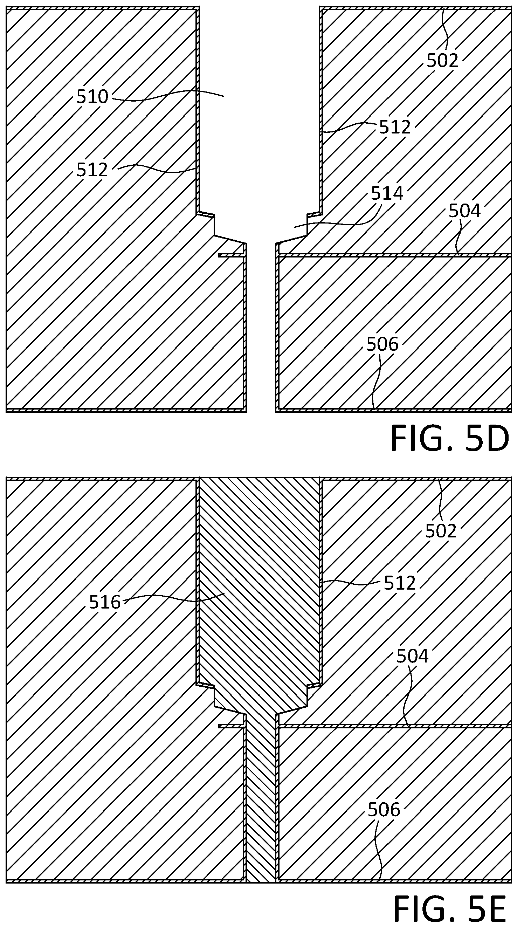

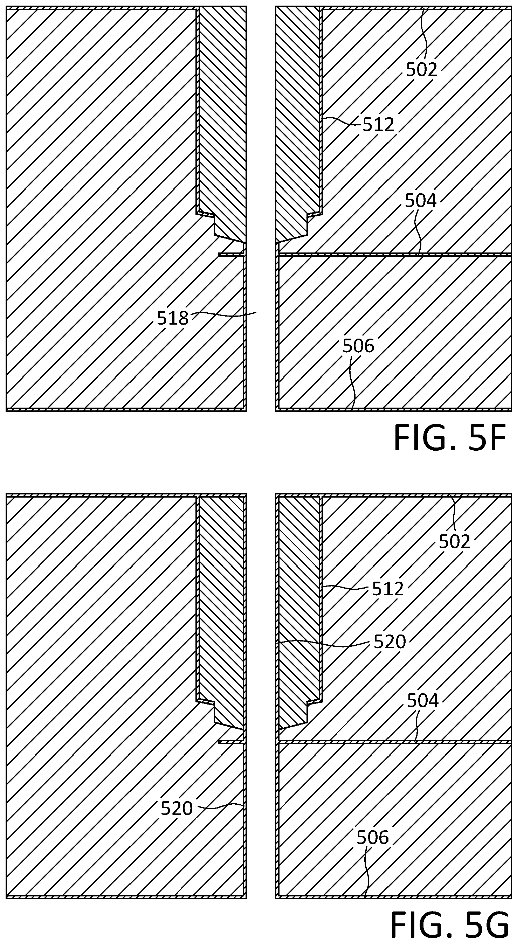

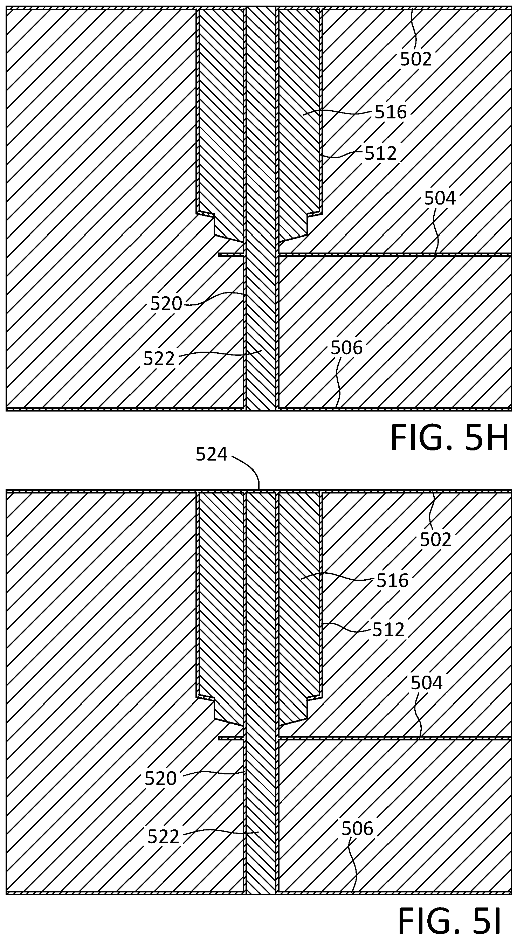

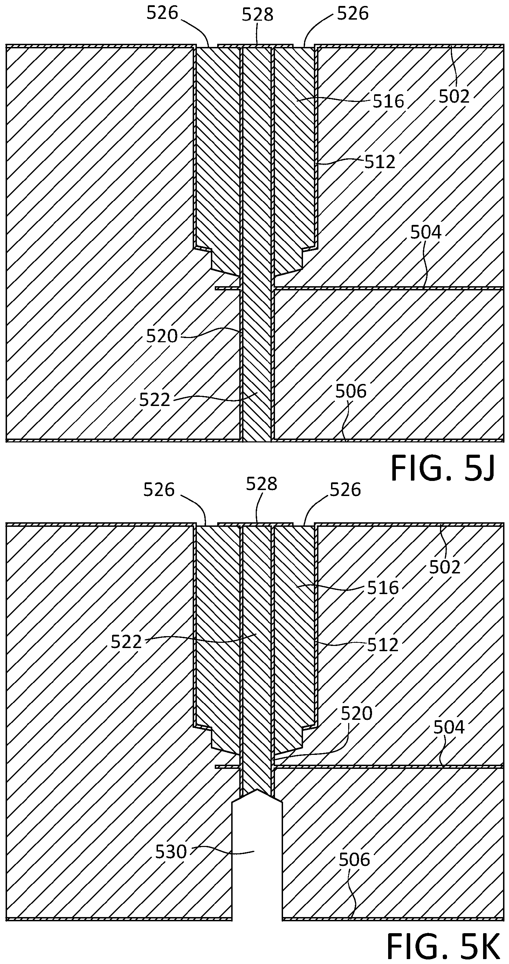

. FIGs. 5A-5K illustrate the various steps carried out to manufacture an alternate variant of via-in-via vertical interconnect 220. In FIG. 5A a first hole 508 is drilled through the PCB 102 with a top layer 502, internal layer 504, and bottom layer 506. The first hole 508 passes through internal layer 504. Next, FIG. 5B illustrates the drilling of a second hole 510 into the PCB that extends to just above the internal layer 504. The bottom of the second hole is above the internal layer 504. The second hole 510 will generally be along and centered around the first hole 508. The diameter of the second hole 510 is larger than the diameter of the first hole 508. Next, the second hole 510 and first hole 508 are plated using copper or some other conductive material as illustrated in FIG. 5C. Then a third hole 514 is drilled in the PCB 102 as illustrated in FIG. 5D. The third hole 514 will generally be along and centered in the second hole 510. The third hole 514 has a diameter larger than the diameter of first hole 508 and smaller than the diameter of the second hole 510. This third hole 514 is shallow and only removes a portion of the plating 512 between the first hole 508 and the second hole 510 to effectively remove the connection between the conductive plating of the second hole 510 and the first hole 508. The bottom of the third hole is above the internal layer 504. Next, the first hole 508, second hole 510, and third hole 514 are filled with polymer filler 516 as illustrated in FIG. 5E. The third hole 514 is generally along and centered in the first hole 508. Then a fourth hole 518 is drilled through the polymer filler 516 and the PCB 102 as illustrated inf FIG. 5F. The fourth hole 518 is generally along and centered in the second hole 510. The drilling of the fourth hole 518 removes the plating from the first hole 508. Then the fourth hole 518 is plated with a copper or other conductive layer to form the inner layer 520 as illustrated in FIG. 5G. The plated fourth hole 518 is then filled with polymer filler 522 as illustrated in FIG. 5H. Next, a copper or other connective layer is plated over the inner filler 522 to form a top pad layer 524 as illustrated in FIG. 5I. Then the top pad layer 524 and top layer 502 are etched to form top layer openings 526 and top via-in-via pad 528 as illustrated in FIG. 5J. Then a fifth hole 530 is drilled from the bottom for the PCB 102 as illustrated inf FIG. 5K. The fifth hole 530 removes a portion of the remaining plated fourth hole 518 so that the inner layer 520 is not connected to the bottom layer 506. The fifth hole 530 is generally along and centered around the fourth hole 518. This manufacturing process results in a via-in-via vertical interconnect that connects a top via-in-via pad 528 to an internal layer 504 in the PCB 102. A signal presented at the surface of pad 520 is free to travel down the plated via 522 without loss of reference to the ground shield provided by the plating 512 of the outer hole 510 until it reaches the desired internal layer connection point 504. Without the protection afforded by the outer ground shield plating 512, the signal would experience fluctuations in impedance as it passed through surrounding ground layers and/or would experience signal corruption due to cross talk as it passed through surrounding signal layers.

In the above description, copper is used as the conductive material. Other types of conductive material may be used as well.

The foregoing disclosure provides illustration and description but is not intended to be exhaustive or to limit the aspects to the precise form disclosed. Modifications and variations may be made in light of the above disclosure or may be acquired from practice of the aspects.

Unless stated otherwise, terms such as "first" and "second" are used to arbitrarily distinguish between the elements such terms describe. Thus, these terms are not necessarily intended to indicate temporal or other prioritization of such elements.

While each of the embodiments are described above in terms of their structural arrangements, it should be appreciated that the aspects also cover the associated methods of using the embodiments described above.

Even though particular combinations of features are recited in the claims and/or disclosed in the specification, these combinations are not intended to limit the disclosure of various aspects. In fact, many of these features may be combined in ways not specifically recited in the claims and/or disclosed in the specification. Although each dependent claim listed below may directly depend on only one claim, the disclosure of various aspects includes each dependent claim in combination with every other claim in the claim set. A phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

No element, act, or instruction used herein should be construed as critical or essential unless explicitly described as such. Also, as used herein, the articles "a" and "an" are intended to include one or more items and may be used interchangeably with "one or more." Furthermore, as used herein, the terms "set" and "group" are intended to include one or more items (e.g., related items, unrelated items, a combination of related and unrelated items, and/or the like), and may be used interchangeably with "one or more." Where only one item is intended, the phrase "only one" or similar language is used. Also, as used herein, the terms "has," "have," "having," and/or the like are intended to be open-ended terms. Further, the phrase "based on" is intended to mean "based, at least in part, on" unless explicitly stated otherwise.

## Claims

1. A method of manufacturing a via-in-via vertical interconnect in a printed circuit board (PCB), comprising:
drilling a first hole through the PCB and through an internal conductive layer of the PCB;
drilling a second hole into a top side of the PCB around the first hole, wherein a diameter of the second hole is greater than a diameter of the first hole and a bottom of the second hole is above the internal conductive layer;
plating the first hole and the second hole with a conductive material to form an outer layer;
drilling a third hole through the PCB along the second hole, wherein a diameter of the third hole is less than the diameter of the second hole and is greater than the diameter of the first hole, a bottom of the third hole is above the internal conductive layer, and a portion of the plating is removed between the first hole and the second hole;
filling the first, second, and third holes with a first non-conductive filler material;
drilling a fourth hole through the first non-conductive filler material;
plating the fourth hole with a conductive material to form an inner layer;
filling the fourth hole with a second non-conductive filler material; and
forming a via-in-via pad on top of the second non-conductive filler connected to the inner layer.

2. The method of claim 1, wherein a fifth hole is drilled through the bottom of the PCB along the fourth hole to remove a portion of the second non-conductive filler and inner layer wherein the top of the fifth hole is below the internal conductive layer.

3. The method of claim 1, wherein forming the via-in-via pad includes
plating a conductive layer over the second non-conductive filler, and
etching the conductive layer over the second non-conductive filler to form top layer openings and the via-in-via pad.

4. The method of claim 1, wherein the first hole is also drilled through a top conductive layer and a bottom conductive layer of the PCB.

5. A printed circuit board (PCB), comprising:
an internal conductive layer; and
a first via-in-via extending from a top surface of the PCB to the internal conductive layer, comprising:
a first outer conductive layer;
a first inner conductive layer inside the first outer conductive layer connected to the internal conductive layer;
a first outer filler between the first outer conductive layer and the first inner conductive layer;
a first inner filler inside the first inner conductive layer; and
a first via-in-via pad over the first inner filler and connected to the first inner conductive layer.

6. The PCB of claim 5, further comprising:
a second via-in-via extending from a surface of the PCB to the internal conductive layer, comprising:
a second outer conductive layer;
a second inner conductive layer inside the second outer conductive layer connected to the internal conductive layer;
a second outer filler between the second outer conductive layer and the second inner conductive layer;
a second inner filler inside the second inner conductive layer; and
a second via-in-via pad over the second inner filler and connected to the second inner conductive layer, wherein the second via-in-via pad is electrically connected to the first via-in-via pad.

7. The PCB of claim 6, wherein the second via-in-via extends from the top surface of the PCB.

8. The PCB of claim 6, wherein the second via-in-via extends from a bottom surface of the PCB.
